# EUROPEAN PATENT APPLICATION

(11) **EP 2 503 263 A2**
(43) Date of publication of application: **26.09.2012**
(21) Application number: 12159809.8
(22) Date of filing: 16.03.2012
(51) Int. Cl.: F25B 21/02

(54) **Heat pump system**

(30) Priority: 22.03.2011 JP 2011062268
(71) Applicant: Kabushiki Kaisha Toyota Jidoshokki, Kariya-shi Aichi 448-8671 (JP)
(72) Inventor: Ueda, Hiromi, Kariya-shi, Aichi 448-8671 (JP); Yokomachi, Naoya, Kariya-shi, Aichi 448-8671 (JP); Okuda, Motoaki, Kariya-shi, Aichi 448-8671 (JP); Nakamura, Junki, Kariya-shi, Aichi 448-8671 (JP)
(74) Representative: TBK

(57) **Abstract**

One aspect of the present invention may include a heat pump system (1) having a Peltier unit (10) installed in an outdoor space (1b), an outdoor heat exchange unit (12) installed in the outdoor space (1b) and connected to the Peltier unit (10) via an outdoor piping (17, 18) in a loop-like fashion to effect heat exchange with the air in the outdoor space (1b) and an indoor heat exchange unit (13) provided in an indoor space (1a) and connected to the Peltier unit (10) in a loop-like fashion by an indoor piping (19) to effect heat exchange with an air in the indoor space (1a). The Peltier unit (10) has a Peltier element (2), a first substrate (3), a second substrate (4), a metal case (6) and a resin case (7). The Peltier element (2) is equipped with a first heat surface and a second heat surface. One surface constitutes a heat-absorbing portion, while the other surface constitutes a heat-radiating portion. The first substrate (3) is in contact with the first heat surface. The second substrate (4) is in contact with the second heat surface. The metal case (6) covers the first substrate (3) and forms a first flow path (6a3) between itself and the first substrate (3). The first flow path (6a3) is connected in a loop-like fashion to the outdoor heat exchange unit (12) by the outdoor piping (17, 18). The resin case (7) covers the second substrate (4) and forms a second flow path (7a3) between itself and the second substrate (4). The second flow path (7a3) is connected in a loop-like fashion to the indoor heat exchange unit (13) by the indoor piping (19).

## Description

This application claims priority to Japanese patent application serial number 2011-62268, the contents of which are incorporated herein by reference.
The present invention relates to a heat pump system utilizing a Peltier element.

Japanese Patent Application Laid-Open No. 2009-36852 discloses an apparatus containing a Peltier element, a metal plate held in contact with one end portion of the Peltier element, an apparatus main body mounted to the metal plate, a casing covering the apparatus main body in cooperation with the metal plate, a heat sink held in contact with the other end portion of the Peltier element and a duct covering the heat sink. When an electric current is passed through the Peltier element, the metal plate side of the Peltier element becomes a heat-absorbing portion, while the heat sink side thereof becomes a heat-radiating portion. The heat-absorbing portion of the Peltier element absorbs heat from the apparatus main body via the metal plate to cool the apparatus main body. The heat-radiating portion of the Peltier element radiates heat to air flowing through the duct via the heat sink.

There exists the need for the utilization of a Peltier element in efficiently adjusting a temperature of a room spaced away from the Peltier element.

One aspect of the present invention can include a heat pump system having a Peltier unit installed in an outdoor space, an outdoor heat exchange unit installed in the outdoor space and connected to the Peltier unit via an outdoor piping in a loop-like fashion to effect heat exchange with the air in the outdoor space and an indoor heat exchange unit provided in an indoor space and connected to the Peltier unit in a loop-like fashion by an indoor piping to effect heat exchange with air in the indoor space. The Peltier unit has a Peltier element, a first substrate, a second substrate, a metal case and a resin case. The Peltier element is equipped with a first heat surface and a second heat surface. One of the surfaces constitutes a heat-absorbing portion, and one of the surfaces constitutes a heat-radiating portion. The first substrate is in contact with the first heat surface. The second substrate is in contact with the second heat surface. The metal case covers the first substrate and forms a first flow path between itself and the first substrate. The first flow path is connected in a loop-like fashion to the outdoor heat exchange unit by the outdoor piping. The resin case covers the second substrate and forms a second flow path between itself and the second substrate. The second flow path is connected in a loop-like fashion to the indoor heat exchange unit by the indoor piping.

The metal case exhibits high thermal conductivity (heat conductivity) because the metal case is formed of metal. And the resin case exhibits low thermal conductivity because the resin case is formed of resin. Accordingly, the efficiency of the heat pump due to the Peltier element is improved. That is, for the purpose of heating, an electric current is supplied to the Peltier element, using the first substrate sides of the Peltier element as a heat-absorbing portion and the second substrate sides thereof as a heat-radiating portion. The heat-absorbing portion of the Peltier element absorbs heat from an outdoor heat medium in the first flow path of the metal case via the first substrate. The outdoor heat medium absorbs heat from the air in the outdoor space via the metal case. Thus, the heat of the air in the outdoor space is utilized to improve the heat pump performance due to the Peltier element. On the other hand, the heat-radiating portion of the Peltier element supplies heat to an indoor heat medium in the second flow path of the resin case via the second substrate. The heat supplied to the indoor heat medium is not easily radiated into the air in the outdoor space due to the low thermal conductivity of the resin case. In comparison to the metal case, the resin case allows a smaller quantity of heat to be radiated. As a result, the quantity of heat supplied to the indoor heat exchange unit is increased, thus achieving an improvement in terms of heating efficiency.

During cooling, an electric current is supplied to the Peltier element, using the first substrate sides of the Peltier element as a heat-radiating portion and the second substrate sides as a heat-absorbing portion. The heat-radiating portion of the Peltier element radiates heat to the outdoor heat medium in the first flow path of the metal case via the first substrate. The outdoor heat medium radiates heat to the air in the outdoor space via the metal case. Thus, the heat is radiated to the air in the outdoor space, whereby the heat pump performance due to the Peltier element is improved. Conversely, the heat-absorbing portion of the Peltier element absorbs heat from the indoor heat medium in the second flow path of the resin case via the second substrate, thereby supplying cold to the indoor heat medium. The cold supplied to the indoor heat medium is not easily radiated to the air in the outdoor space due to the low thermal conductivity of the resin case. In comparison to the metal case, the resin case allows a smaller quantity of cold to be radiated. As a result, the quantity of cold supplied to the indoor heat exchange unit increases, resulting in improved air-conditioning efficiency.

Additional objects, features, and advantages, of the present invention will be readily understood after reading the following detailed description together with the claims and the accompanying drawings, in which:
FIG. 1 is a configuration diagram of a heat pump system;
FIG. 2 is a perspective view of a Peltier unit;
FIG. 3 is an exploded perspective view of the Peltier unit;
FIG. 4 is an exploded perspective view of a Peltier module;
FIG. 5 is an inverted perspective view of the lower half of a Peltier module; and
FIG. 6 is a cross-sectional view taken along line VI-VI in FIG. 2.

Each of the additional features and teachings disclosed above and below may be utilized separately or in conjunction with other features and teachings to provide improved heat pump systems. Representative examples of the present invention, which examples utilize many of these additional features and teachings both separately and in conjunction with one another, will now be described in detail with reference to the attached drawings. This detailed description is merely intended to teach a person of skill in the art further details for practicing preferred aspects of the present teachings and is not intended to limit the scope of the invention. Only the claims define the scope of the claimed invention. Therefore, combinations of features and steps disclosed in the following detailed description may not be necessary to practice the invention in the broadest sense, and are instead taught merely to particularly describe representative examples of the invention. Moreover, various features of the representative examples and the dependent claims may be combined in ways that are not specifically enumerated in order to provide additional useful configurations of the present teachings.

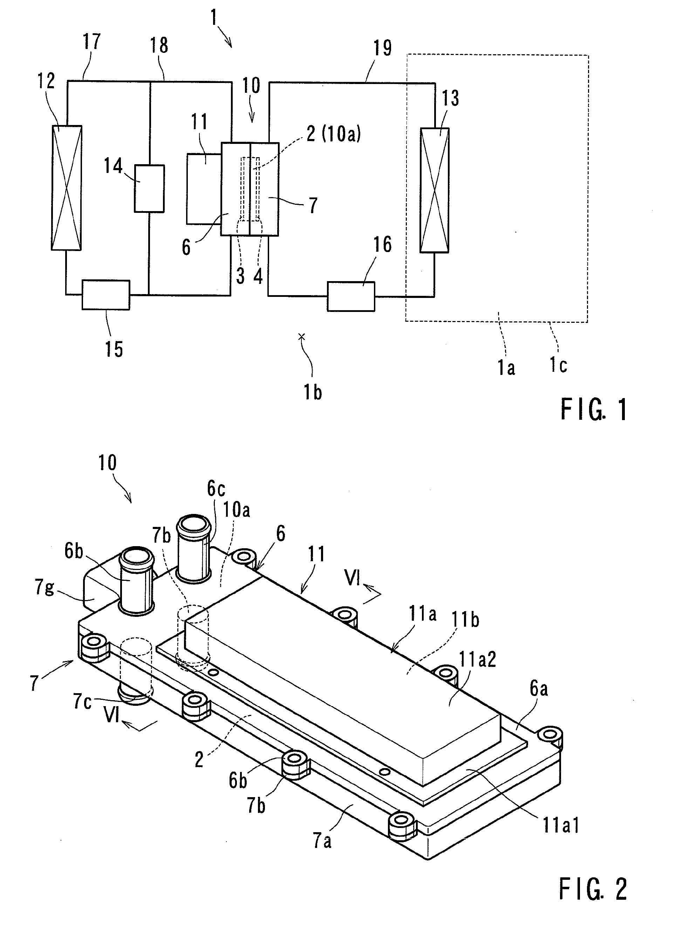

An embodiment of the present invention will be described with reference to Figs. 1 to 6. As shown in Fig. 1, a heat pump system 1 is provided in a vehicle. The vehicle has a room (crew room) 1c to be warmed by the heat pump system 1. The heat pump system 1 has a Peltier unit 10, an outdoor heat exchange unit 12 and an indoor heat exchange unit 13.

As shown in Fig. 1, an outdoor heat exchange unit (radiator) 12 may be installed in an outdoor space 1b outside the room 1c. The outdoor heat exchange unit 12 is connected to an engine 14 of the vehicle by outdoor piping 17 in a loop-like fashion. A pump 15 is provided at a point of the outdoor piping 17. The pump 15 circulates an outdoor heat medium (liquid coolant) between the engine 14 and the outdoor heat exchange unit 12. The outdoor heat medium receives heat (warm heat) from the engine 14, and radiates the heat into the air in the outdoor space 1b via the outdoor heat exchange unit 12.

As shown in Fig. 1, the Peltier unit 10 is installed in the outdoor space 1b. The Peltier unit 10 is connected in a loop-like fashion to the outdoor heat exchange unit 12 by outdoor piping 18 connected to the outdoor piping 17 and is connected to the outdoor heat exchange unit 12 in parallel with the engine 14. The Peltier unit 10 absorbs heat from the outdoor heat medium, thereby cooling it. Accordingly, the outdoor heat medium is cooled not only by the outdoor heat exchange unit 12 but also by the Peltier unit 10.

As shown in Fig. 1, the Peltier unit 10 is connected to the indoor heat exchange unit 13 in a loop-like fashion via indoor piping 19. A pump 16 is provided at a point in the indoor piping 19. The pump 16 circulates an indoor heat medium (liquid coolant) between the Peltier unit 10 and the indoor heat exchange unit 13. The indoor heat medium receives heat from the Peltier unit 10, and dissipates the heat into the air in an indoor space 1a from the indoor heat exchange unit 13. In this way, the indoor heat exchange unit 13 warms the air in the indoor space 1a.

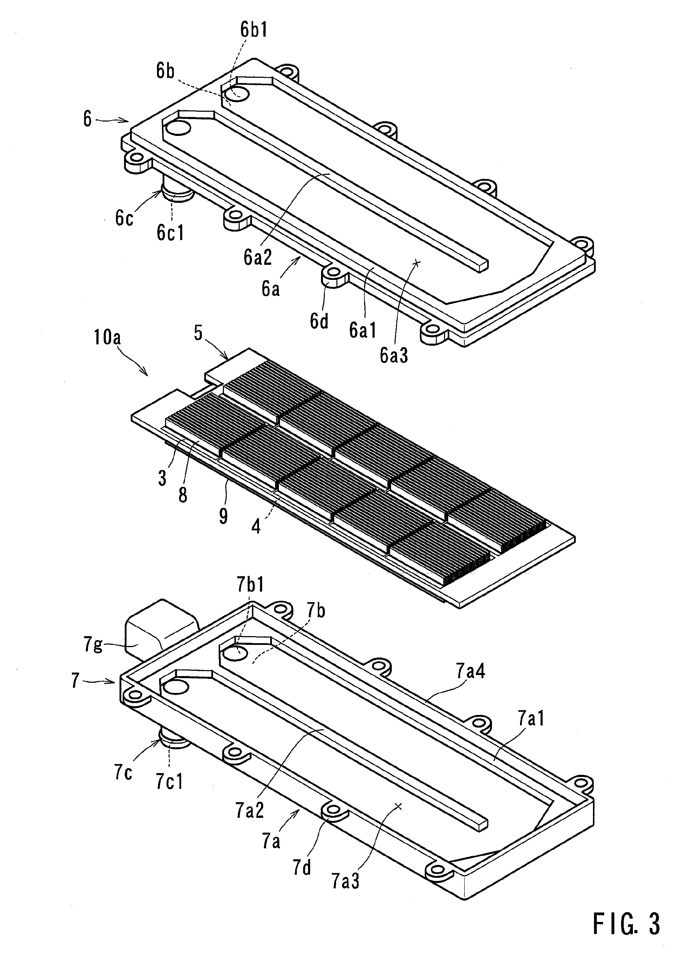

As shown in Figs. 2 and 3, the Peltier unit 10 has a metal case 6, a resin case 7, and a Peltier module 10a. The metal case 6 is formed of a metal with high thermal conductivity such as aluminum, stainless steel, iron or copper. The resin case 7 is formed of a resin with low thermal conductivity. The metal case 6 and the resin case 7 respectively have plate-like case main bodies 6a and 7a, tubular introduction pipes 6b and 7b, and tubular discharge pipes 6c and 7c.

As shown in Fig. 3, the case main bodies 6a and 7a respectively have peripheral wall portions 6a1 and 7a1, and partition portions 6a2 and 7a2. The peripheral wall portions 6a1 and 7a1, respectively, protrude vertically along the outer peripheries of the case main bodies 6a and 7a. On the outer peripheral portion of the peripheral wall portion 7a1, there is formed an outer wall portion 7a4 further protruding vertically from the peripheral wall portion 7a1.

As shown in Fig. 3, the partition portions 6a2 and 7a2 respectively extend longitudinally in the middle regions of the case main bodies 6a and 7a and protrude vertically. The partition portions 6a2 and 7a2 are positioned at the middle regions in the width direction of the case main bodies 6a and 7a. First and second flow paths 6a3 and 7a3 are formed by the peripheral wall portions 6a1 and 7a1 and the partition portions 6a2 and 7a2. The first and second flow paths 6a3 and 7a3 respectively extend in a U-shape on the surfaces of the case main bodies 6a and 7a.

As shown in Figs. 2 and 3, the introduction pipes 6b and 7b and the discharge pipes 6c and 7c may extend vertically from the case main bodies 6a and 7a. The introduction pipes 6b and 7b and the discharge pipes 6c and 7c may be provided adjacently at one end of the case main bodies 6a and 7a. The introduction pipes 6b and 7b may have introduction paths 6b1 and 7b1 communicating with first and second flow paths 6a3 and 7a3. The discharge pipes 6c and 7c have discharge paths 6c1 and 7c1 also communicating with the first and second flow paths 6a3 and 7a3.

As shown in Fig. 2, the resin case 7 integrally has a connector portion 7g. The connector portion 7g may be of a tubular configuration and protrudes sideways from the case main body 7a. A connector portion of a converter 11 may be connected to the connector portion 7g.

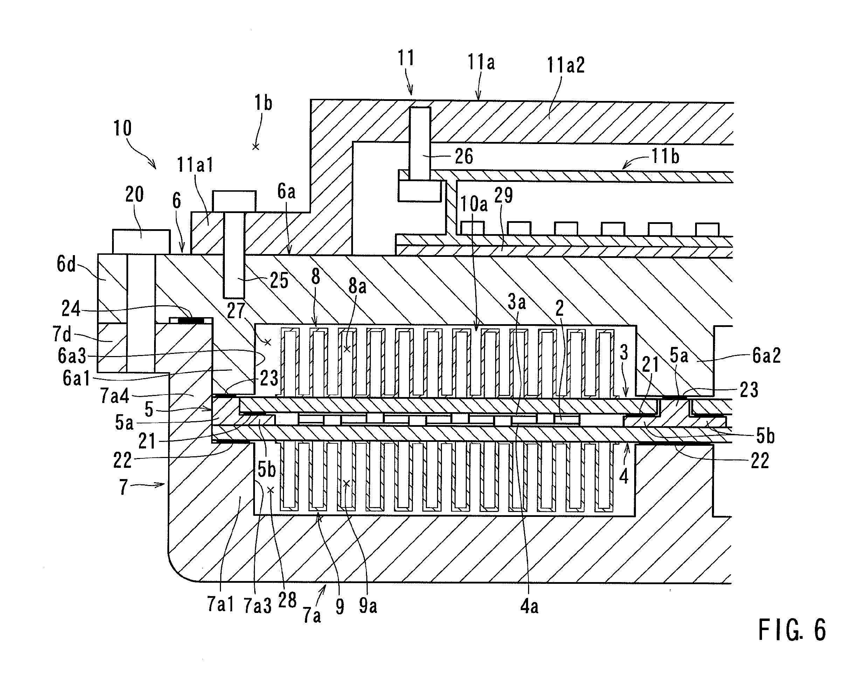

As shown in Figs. 2 and 6, the converter (heat generator) 11 has a converter main body 11b and a case 11a. The converter main body 116 converts a voltage supplied from a battery mounted in the vehicle to a predetermined voltage and supplies an electric current to the Peltier module 10a via the connector portion 7g. The case 11a is formed of a metal with high thermal conductivity such as aluminum, stainless steel, iron or copper. The case 11 a integrally has a case main body 11a2 and a flange 11a1.

As shown in Fig. 6, the case main body 11a2 houses a converter main body 11b. The converter main body 11b is mounted to the case main body 11a2 by a bolt 26 so as to allow positional adjustment. The flange 11a1 protrudes outwardly from an outer peripheral edge of the case main body 11a2 and is mounted to a surface of the metal case 6 by a bolt 25. The converter main body 11b is held in contact with the metal case 6 through an intermediary such as grease 29, which preferably allows heat conduction.

As shown in Figs. 2 and 3, the metal case 6 and the resin case 7 have a plurality of connection portions 6d and 7d. The connection portions 6d are of a cylindrical configuration and are formed on side surfaces of the case main body 6a. The connection portions 7d are of a cylindrical configuration and are formed on side surfaces of the outer wall portion 7a4. As shown in Fig. 6, the peripheral wall portion 6a1 of the metal case 6 is inserted into the inner side of the outer wall portion 7a4 of the resin case 7, whereby the connection portions 6d and 7d are brought into contact with each other. The connection portions 6d and 7d are fastened together by bolts 20.

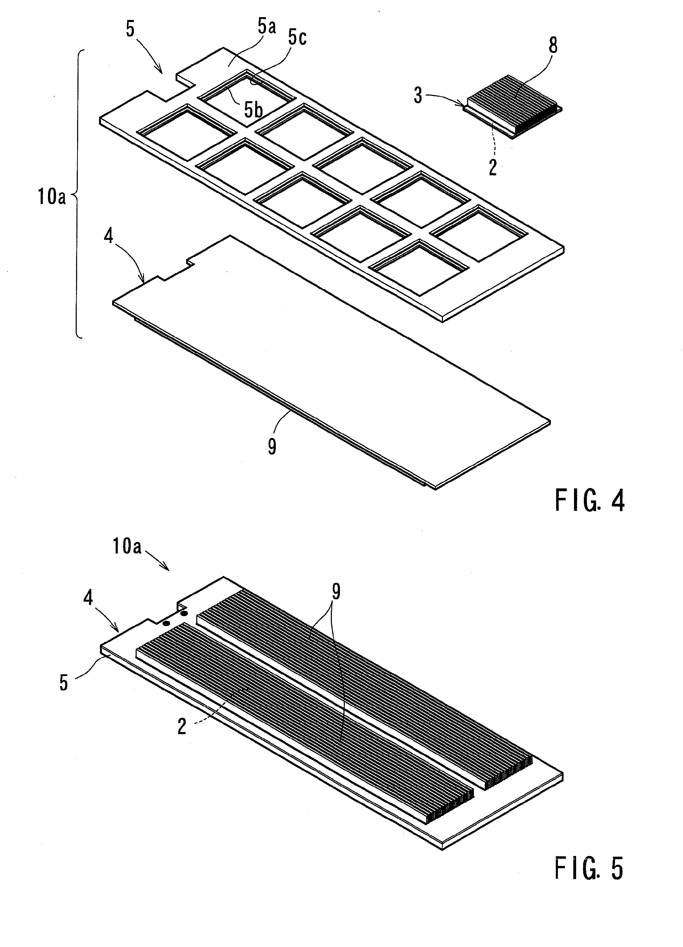

As shown in Figs. 4 and 5, the Peltier module 10a has Peltier elements 2, first and second substrates 3 and 4, and first fin 8 and second fins 9. Fig. 5 shows an inverted bottom half of the Peltier module 10a, shown in Figs. 3 and 4. The Peltier element 2 is composed of different metals, conductors, or semiconductors. When a DC current is supplied thereto, the Peltier element 2 provides a Peltier effect. The Peltier element 2 has a pair of heat surfaces, one of which serves as a heat absorption surface to absorb heat, and the other of which serves as a heat radiation heat to radiate heat. The Peltier element 2 is provided in a plurality of rows in the longitudinal direction with respect to the first and second substrates 3 and 4. The Peltier element 2 is also provided in a plane in the lateral direction with respect to the first and second substrates 3 and 4.

As shown in Figs. 3 and 4, the Peltier module 10a has a plurality of (e.g., ten) small first substrates 3 and one large second substrate 4. As shown in Fig. 6, sets of wiring 3a and 4a are printed on the first substrates 3 and the second substrate 4. The Peltier elements 2 are connected to the sets of wiring 3a and 4a by soldering. The sets of wiring 3a and 4a cooperate to connect the plurality of Peltier elements 2 in series. Accordingly, an electric current flows alternately between the first and second substrates 3 and 4 via each Peltier element 2.

As shown in Fig. 3, each first substrate 3 is provided with one first fin 8. As shown in Fig. 5, the second substrate 4 is provided with two second fins 9. The first fin 8 and second fins 9 protrude from the first and second substrates 3 and 4 in the direction opposite to the Peltier elements 2. As shown in Fig. 6, the first fin 8 and second fins 9 are of a plate-like and zigzag configuration, and are installed within the first and second flow paths 6a3 and 7a3. Gaps 8a and 9a are formed between the zigzag turns of first fin 8 and second fins 9. The gaps 8a and 9a expand in the longitudinal direction of the first and second flow paths 6a3 and 7a3 so as not to cut off the first and second flow paths 6a3 and 7a3. The positional relationship between the first substrate 3 and the second substrate 4 is determined by a frame member 5.

As shown in Figs. 4 and 6, the frame member 5 is formed of a resin with low thermal conductivity (heat conductivity), and integrally has a frame main body 5a and a protruding portion 5b. The frame main body 5a has a plurality of holes 5c and the first substrates 3 are installed in each hole 5c. The frame main body 5a extends along the outer peripheral edges of the first substrates 3, determining the positions of the first substrates 3 with respect to the frame member 5.

As shown in Fig. 6, the protruding portions 5b protrude between the first and second substrates 3 and 4 from the frame main body 5a. The protruding portion 5b determines the distance in the thickness direction between the first and second substrates 3 and 4. The protruding portion 5b prevents the first and second substrates 3 and 4 from approaching each other to determine a distance between the first and second substrates 3 and 4. Thus, the protruding portion 5b suppresses the crushing of the Peltier elements 2. The protruding portion 5b extends along the entire outer periphery of the second substrate 4. A liquid gasket 21 seals the space between the protruding portion 5b and the first substrates 3.

As shown in Fig. 6, a liquid gasket 22 seals the space between the second substrate 4 and the resin case 7. A liquid gasket 23 seals the space between the frame member 5 and the metal case 6. A liquid gasket 24 seals the space between resin case 7 and the metal case 6.

As shown in Fig. 6, when preparing the Peltier unit 10, the Peltier module 10a is installed on the inner side of the outer wall portion 7a4 of the resin case 7. The metal case 6 is inserted into the inner side of the outer wall portion 7a4 of the resin case 7. The connection portions 6d and 7d abut each other and may be fastened together by the bolts 20. The converter 11 is mounted to the metal case 6 by the bolt 25.

When preparing the heat pump system 1, the outdoor piping 18 shown in Fig. 1 may be connected to the introduction pipe 6b and the discharge pipe 6c of the Peltier unit 10 shown in Fig. 2. The indoor piping 19 is connected to the introduction pipe 7b and the discharge pipe 7c. The connector portion 7g shown in Fig. 2 and the converter 11 are electrically connected to each other to supply an electric current from the converter 11 to the Peltier elements 2 shown in Fig. 4. Each Peltier element 2 causes heat absorption at a side end portion of the first substrate 3 and heat radiation at a side end portion of the second substrate 4.

As shown in Fig. 6, the Peltier elements 2 absorb heat from an outdoor heat medium 27 flowing in the first flow path 6a3 via the first substrates 3 and the first fins 8. The outdoor heat medium 27 is cooled and its temperature becomes lower than that of the air in the outdoor space 1b. The outdoor heat medium 27 absorbs heat from the air in the outdoor space 1b via the metal case 6 and also absorbs heat from the converter 11 generating heat. The Peltier elements 2 supply heat to an indoor heat medium 28 flowing in the second flow path 7a3 via the second substrate 4 and the second fins 9. The indoor heat medium 28 conveys heat to the indoor heat exchange unit 13 shown in Fig. 1.

As shown in Fig. 1, the heat pump system 1 has the Peltier unit 10 installed in the outdoor space 1b. The outdoor heat exchange unit 12 is installed in the outdoor space 1b and connected to the Peltier unit 10 via the outdoor piping 17, 18 in a loop-like fashion to effect heat exchange with the air in the outdoor space 1b. The indoor heat exchange unit 13 is provided in the indoor space 1a and connected to the Peltier unit 10 in a loop-like fashion by the indoor piping 19 to effect heat exchange with the air in the indoor space 1a.

As shown in Figs. 1 and 6, the Peltier unit 10 has the Peltier elements 2, the first substrates 3, the second substrate 4, the metal case 6 and the resin case 7. Each of the Peltier elements 2 may be equipped with at least one first heat surface and at least one second heat surface. One surface constitutes a heat-absorbing portion while the other of the surfaces constitutes a heat-radiating portion. The first substrates 3 are in contact with the first heat surface(s). The second substrate 4 is in contact with the second heat surface(s). The metal case 6 covers the first substrates 3 and forms the first flow path 6a3 between itself and the first substrates 3. The first flow path 6a3 is connected in a loop-like fashion to the outdoor heat exchange unit 12 by the outdoor piping 17, 18. The resin case 7 covers the second substrate 4 and forms the second flow path 7a3 between itself and the second substrate 4. The second flow path 7a3 is connected in a loop-like fashion to the indoor heat exchange unit 13 by the indoor piping 19.

The metal case 6 exhibits high thermal conductivity because the metal case 6 is formed of metal. The resin case 7 exhibits low thermal conductivity because the resin case 7 is formed of resin. As such, the efficiency of the heat pump using the Peltier elements 2 is improved. During heating, an electric current is supplied to the heat-absorbing first substrate 3 sides and to the heat-radiating second substrate 4 sides of the Peltier elements 2. The heat-absorbing portions of the Peltier elements 2 absorb heat from the outdoor heat medium 27 in the first flow path 6a3 of the metal case 6 via the first substrates 3. The outdoor heat medium 27 absorbs heat from the air in the outdoor space 1b via the metal case 6. Thus, the heat of the air in the outdoor space 1b is utilized to improve the heat pump performance through use of the Peltier elements 2. Conversely, the heat-radiating portions of the Peltier elements 2 supply heat to the indoor heat medium 28 in the second flow path 7a3 of the resin case 7 via the second substrate 4. The heat supplied to the indoor heat medium 28 is not easily radiated into the air in the outdoor space 1b due to the low conductivity of the resin case 7. In comparison to the metal case, the resin case allows a smaller quantity of heat to be radiated. As a result, the quantity of heat supplied to the indoor heat exchange unit 13 is increased, thus achieving an improvement in terms of heating efficiency.

As shown in Figs. 1 and 6, the heat pump system 1 has a heat generating body (converter 11) mounted to the metal case 6 so as to allow heat exchange. An electric current is supplied to the Peltier elements 2 such that the first substrate 3 sides of the Peltier elements 2 constitute heat-absorbing portions. Thus, the heat-absorbing portions of the Peltier elements 2 can absorb heat not only from the air in the outdoor space 1b but also from the heat generating body (converter 11) via the metal case 6. As a result, the exhaust heat of the heat generating body is utilized, thereby improving the heat pump performance due to the Peltier elements 2. Consequently, the heat generating body (converter 11) can be cooled by the Peltier elements 2 via the metal case 6.

While the invention has been described with reference to specific configurations, it will be apparent to those skilled in the art that many alternatives, modifications and variations may be made without departing from the scope of the present invention. Accordingly, the present invention is intended to embrace all such alternatives, modifications and variations that may fall within the spirit and scope of the appended claims. For example, the present invention should not be limited to the representative configurations.

The heat pump system 1 may be used for either the heating or air conditioning of a vehicle room 1c. In other embodiments, the functionalities of certain members may be changed. For example, the first substrate side 3 could be used, instead, as the heat-radiating portion, due to a direction of an electric current supplied to the Peltier elements 2. Similarly, the second substrate side 4 could be used, instead, as the heat-absorbing portion.

The Peltier elements 2 radiate heat to the outdoor heat medium 27 in the first flow path 6a3 of the metal case 6 via the heat-radiating first substrates 3. The outdoor heat medium 27 radiates heat to the air in the outdoor space 1b via the metal case 6. Thus, the heat is radiated to the air in the outdoor space 1b, whereby the heat pump performance of the Peltier elements 2 is improved. In a similar fashion, the heat-absorbing portions of the Peltier elements 2 absorb heat from the indoor heat medium 28 in the second flow path 7a3 of the resin case 7 via the second substrate 4, thereby cooling the indoor heat medium 28. The cold supplied to the indoor heat medium 28 is not easily radiated to the air in the outdoor space 1b due to the low thermal conductivity of the resin case 7. As compared with the metal case, the resin case allows a smaller quantity of cold air to be radiated. As a result, the quantity of cold air supplied to the indoor heat exchange unit increases, thereby resulting in improved air-conditioning.

The heat pump system 1 may be used for the air conditioning and/or heating of a vehicle room 1c, an interior of a loading chamber (chamber) of a vehicle, or the interior of any such room.

The heat medium supplied to the metal case 6 and the resin case 7 may be any composition capable of thermal transmission. Preferred compositions include liquids and gases.

The heat pump system 1 may or may not have the engine 14 shown in Fig. 1.

The heat pump system 1 may use various other devices as a heat generating body. For example, an electric apparatus such as an inverter, a motor, a battery, or a heat engine such as an internal combustion engine may be used for the heat generating body.

The heat pump system 1 may be provided in a plug-in hybrid vehicle, an electric vehicle, or any engine vehicle.
One aspect of the present invention may include a heat pump system (1) having a Peltier unit (10) installed in an outdoor space (1b), an outdoor heat exchange unit (12) installed in the outdoor space (1b) and connected to the Peltier unit (10) via an outdoor piping (17, 18) in a loop-like fashion to effect heat exchange with the air in the outdoor space (1b) and an indoor heat exchange unit (13) provided in an indoor space (1a) and connected to the Peltier unit (10) in a loop-like fashion by an indoor piping (19) to effect heat exchange with an air in the indoor space (1a). The Peltier unit (10) has a Peltier element (2), a first substrate (3), a second substrate (4), a metal case (6) and a resin case (7). The Peltier element (2) is equipped with a first heat surface and a second heat surface. One surface constitutes a heat-absorbing portion, while the other surface constitutes a heat-radiating portion. The first substrate (3) is in contact with the first heat surface. The second substrate (4) is in contact with the second heat surface. The metal case (6) covers the first substrate (3) and forms a first flow path (6a3) between itself and the first substrate (3). The first flow path (6a3) is connected in a loop-like fashion to the outdoor heat exchange unit (12) by the outdoor piping (17, 18). The resin case (7) covers the second substrate (4) and forms a second flow path (7a3) between itself and the second substrate (4). The second flow path (7a3) is connected in a loop-like fashion to the indoor heat exchange unit (13) by the indoor piping (19).

## Claims

1. A heat pump system (1) comprising:
a Peltier unit (10) installed in an outdoor space (1b);
an outdoor heat exchange unit (12) installed in the outdoor space (1b) and connected to the Peltier unit (10) via an outdoor piping (17, 18) in a loop-like fashion to effect heat exchange with air in the outdoor space (1b); and
an indoor heat exchange unit (13) provided in an indoor space (1a) and connected to the Peltier unit (10) in a loop-like fashion by an indoor piping (19) to effect heat exchange with air in the indoor space (1a),
wherein the Peltier unit (10) comprises:
a Peltier element (2) equipped with a first heat surface and a second heat surface, one of the surfaces constituting a heat-absorbing portion, one of the surfaces constituting a heat-radiating portion,
a first substrate (3) being in contact with the first heat surface,
a second substrate (4) being in contact with the second heat surface,
a metal case (6) covering the first substrate (3) and forming a first flow path (6a3) between the metal case (6) and the first substrate (3), the first flow path (6a3) connected in a loop-like fashion to the outdoor heat exchange unit (12) by the outdoor piping (17, 18), and
a resin case (7) covering the second substrate (4) and forming a second flow path (7a3) between the resin case (7) and the second substrate (4), the second flow path (7a3) connected in a loop-like fashion to the indoor heat exchange unit (13) by the indoor piping (19).

2. A heat pump system (1) as in claim 1, further comprising a heat generating body (11) mounted to the metal case (6) so as to allow heat exchange,
wherein an electric current is supplied to the Peltier element (2) such that the first heat surface of the Peltier element (2) constitutes the heat-absorbing portion.
